# EUROPEAN PATENT SPECIFICATION

(11) **EP 3 027 578 B1**
(45) Date of publication and mention of the grant of the patent: **27.12.2017**
(21) Application number: 14850054.9
(22) Date of filing: 22.08.2014
(51) Int. Cl.: B28B 17/00, C04B 35/01, C04B 35/053, C04B 35/453, C04B 35/626, C04B 35/64, C04B 35/26, H01F 1/34, H01F 1/36, H01F 41/02, H05K 9/00

(54) **WAVE ABSORBING MATERIAL AND METHOD OF PREPARING THE SAME**
WELLENABSORBIERENDES MATERIAL UND VERFAHREN ZUR HERSTELLUNG DAVON
MATÉRIAU ABSORBANT DES ONDES ET SON PROCÉDÉ DE PRÉPARATION

(30) Priority: 25.09.2013 CN 201310441214
(43) Date of publication of application: 08.06.2016
(73) Proprietor: BYD Company Limited, Shenzhen, Guangdong 518118 (CN)
(72) Inventor: LIU, Houyin, Shenzhen, Guangdong 518118 (CN); KONG, Xianjun, Shenzhen, Guangdong 518118 (CN); CHEN, Dajun, Shenzhen, Guangdong 518118 (CN)
(74) Representative: Hoffmann Eitle
(86) International application number: PCT/CN2014/085053
(87) International publication number: WO 2015/043347

(56) References cited:
- EP-A1- 0 891 955
- EP-A1- 2 277 838
- CN-A- 1 294 099
- CN-A- 1 514 450
- CN-A- 102 173 762
- JP-A- H1 179 785
- JP-A- 2010 248 031

## Description

### FIELD

Exemplary embodiments of the present disclosure relate generally to magnetic materials, and more particularly to a wave absorbing material and a method of preparing the wave absorbing material.

### BACKGROUND

A magnetic disk in a receiving terminal module in an electromagnetic-inducted wireless charging system may absorb electromagnetic waves entering into the material, which may prevent the electromagnetic wave from interfering electromagnetic signals of the receiving terminal device, and prevent the electromagnetic wave from generating heating on components such as batteries in the receiving terminal. For a currently used composite material made from an Al-Si-Fe alloy and a resin, it is required that the particles of Al-Si-Fe alloy have a uniform and fixed shape, and the arrangement of the particles in the resin have a certain orientation; otherwise, the initial magnetic permeability of the composite material may be very low. Even if the arrangement of the particles in the resin has a good orientation, the initial magnetic permeability of the material may not be high due to the existence of certain amount of resins. However, the resistivity of the material is relatively high because of the existence of metals. These disadvantages may lead to a low efficiency and poor safety of the wireless charging system, and an obvious heating effect of components such as the battery.

CN 102211929A discloses a NiCuZn ferrite which is sintered in low temperature and has high magnetic permittivity. The Ni-Cu-Zn ferrite contains a main composition selected from the group consisting of Fe₂O₃, ZnO, CuO and NiO; and an auxiliary composition selected from the group consisting of NaCO₃, B₂O₃ and Ta₂O₅. According to the main composition based on oxides, Fe₂O₃ ranges from 40.5 mol% to 49.6 mol%; ZnO ranges from 30 mol% to 47 mol%; CuO ranges from 5 mol% to 20 mol%; and the balance is NiO. Based on the weight of the main composition, the sum of the auxiliary composition ranges from 0.16 wt% to 1.65 wt%. The Ni-Cu-Zn ferrite has a relatively high magnetic conductivity, however, it still cannot meet the requirements because of a relatively high magnetic loss. JP H1179785 A and JP 2010 248031 A disclose soft-magnetic glass based on SiO₂ as major component, with additions of Fe₂O₃, ZnO, MgO, CeO₂, and P₂O₅.

### SUMMARY

Embodiments of the present disclosure seek to solve at least one of the problems.

According to a first aspect of the present disclosure, a wave absorbing material is provided. The wave absorbing material includes: a main composition containing at least one of Fe₂O₃, MnO, ZnO and MgO; an auxiliary composition containing at least CeO₂ and P₂O₅, and a sintering additive, in which the molar ratio of CeO₂ to P₂O₅ is 1: 1 to 2: 1 and is as defined below.

According to a second aspect of the present disclosure, a method of preparing the wave absorbing material is provided. The method includes: providing a mixture comprising the main composition and the sintering additive; first grinding and first sintering the mixture together with a solvent and a dispersant to form a first powder; second grinding the first powder together with CeO₂ and P₂O₅ to form a second powder; and molding and second sintering the second powder.

According to embodiments of the present disclosure, the wave absorbing material contains CeO₂ and P₂O₅, and the molar ratio of CeO₂ to P₂O₅ is 1: 1 to 2: 1. The CeO₂ and P₂O₅ may have a synergistic effect on each other, and therefore the resistivity and the initial magnetic permeability of the wave absorbing material may be both improved. In addition, the magnetic loss of the wave absorbing material may be decreased to a very low level, which may greatly improve the charging efficiency of a device using this wave absorbing material.

Additional aspects and advantages of embodiments of present disclosure will be given in part in the following descriptions, become apparent in part from the following descriptions, or be learned from the practice of the embodiments of the present disclosure.

### BRIEF DESCRIPTION OF THE DRAWINGS

These and other aspects and advantages of embodiments of the present disclosure will become apparent and more readily appreciated from the following descriptions made with reference to the accompanying drawings, in which:

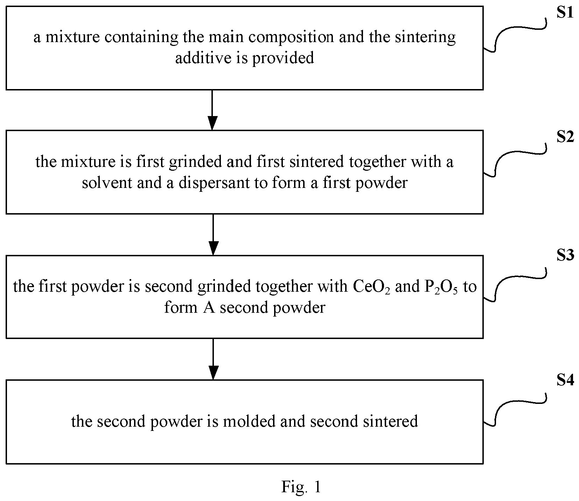

Fig. 1 is a flow chart showing a method of preparing a wave absorbing material according to an embodiment of the present disclosure.

### DETAILED DESCRIPTION

Reference will be made in detail to embodiments of the present disclosure. The embodiments described herein with reference to drawings are explanatory, illustrative, and used to generally understand the present disclosure. The embodiments shall not be construed to limit the present disclosure. In addition, terms such as "first" and "second" are used herein for purposes of description and are not intended to indicate or imply relative importance or significance.

For the purpose of the present description and of the following claims, the definitions of the numerical ranges always include the extremes unless otherwise specified.

According to a first aspect of the present disclosure, a wave absorbing material is provided. The wave absorbing material includes a main composition, an auxiliary composition and a sintering additive. The main composition contains at least one of ferric oxide (Fe₂O₃), manganese oxide (MnO), zinc oxide (ZnO) and magnesium oxide (MgO). The auxiliary composition contains at least cerium dioxide (CeO₂) and phosphorus pentoxide (P₂O₅). The molar ratio of CeO₂ to P₂O₅ is 1: 1 to 2: 1.

According to some embodiments of the present disclosure, the wave absorbing material contains CeO₂ which belongs to lanthanide metal oxides and has a high melting point. The CeO₂ may refine the grain, enhance the resistivity and the initial magnetic permeability, and reduce eddy current loss of the wave absorbing material. Meanwhile, the wave absorbing material contains a nonmetallic oxide P₂O₅. The P₂O₅ may increase the vacancy of metal ions near the grain boundary, accelerate the movement of the grain boundary, and increase the density and the initial magnetic permeability of the wave absorbing material. According to embodiments of the present disclosure, CeO₂ and P₂O₅ are contained, and the molar ratio of CeO₂ to P₂O₅ is 1: 1 to 2: 1. Then CeO₂ and P₂O₅ may have a synergistic effect on each other, and the resistivity and the initial magnetic permeability of the material may be both increased. In addition, the magnetic loss of the wave absorbing material may be decreased to a very low level, which may greatly improve the charging efficiency of a device using this wave absorbing material.

According to the present disclosure, based on the total molar amount of the wave absorbing material, Fe₂O₃ ranges from 40 mol% to 54 mol%, MnO ranges from 12 mol% to 20 mol%, ZnO ranges from 22 mol% to 25 mol%, MgO ranges from 5 mol% to 10 mol%, CeO₂ ranges from 0.1 mol% to 3.5 mol%, P₂O₅ ranges from 0.1 mol% to 2.5 mol%, and the sintering additive ranges from 0.2 mol% to 3.5 mol%.

According to some embodiments of the present disclosure, based on the total molar amount of the wave absorbing material, Fe₂O₃ ranges from 45 mol% to 50 mol%, MnO ranges from 13 mol% to 16 mol%, ZnO ranges from 22 mol% to 25 mol%, MgO ranges from 5 mol% to 10 mol%, CeO₂ ranges from 1.5 mol% to 3.0 mol%, P₂O₅ ranges from 1 mol% to 2 mol%, and the sintering additive ranges from 0.2 mol% to 3.5 mol%.

According to some embodiments of the present disclosure, the sintering additive may reduce the sintering temperature of the wave absorbing material, and therefore the magnetic disk may form a liquid phase sintering at a relatively lower temperature. Then the density and the intensity of the final wave absorbing material may be both increased. In some embodiments, the sintering additive contains at least one of Nb₂O₅, MoO₃, Bi₂O₃, V₂O₅ and SiO₂.

According to some embodiments of the present disclosure, based on the total molar amount of the wave absorbing material, Nb₂O₅ ranges from 0.1 mol% to 2.5 mol%, MoO₃ ranges from 0.1 mol% to 1.5 mol%, Bi₂O₃ ranges from 0.2 mol% to 1.5 mol%, V₂O₅ ranges from 0.1 mol% to 1.5 mol%, and SiO₂ ranges from 0.2 mol% to 2.5 mol%.

In some embodiments of the present disclosure, Nb₂O₅ may increase the thickness and resistivity of the grain boundary, so as to increase the resistivity of the material. The amount of Bi₂O₃ is controlled, and therefore a liquid phase sintering may be formed. Then the grain growth is promoted, the density of the material is improved, and the porosity both outside and inside the grain is reduced. With a proper amount of Bi₂O₃, and the initial magnetic permeability of the wave absorbing material may be enhanced. A small amount of SiO₂ powder may dilute Fe, and the electrical conductivity of Fe²⁺ and Fe³⁺ may be limited. Thus the resistivity of the wave absorbing material is improved. SiO₂ powders have some advantages, such as good surface permeability, large specific area, low density, good mechanical property and good thermostability. With the addition of SiO₂ powders, the strength of the wave absorbing material may be improved. With the addition of MoO₃, Bi₂O₃ and V₂O₅, the sintering temperature may be reduced, and the wave absorbing material may form a liquid phase sintering at a relatively lower temperature. Then the density and strength of the wave absorbing material may be increased.

According to a second aspect of the present disclosure, a method of preparing the wave absorbing material is provided. As shown in Fig. 1, the method includes steps S1-S4.

At step S1, a mixture containing the main composition and the sintering additive is provided.

At step S2, the mixture is first grinded and first sintered together with a solvent and a dispersant to form a first powder.

At step S3, the first powder is second grinded together with CeO₂ and P₂O₅ to form a second powder.

At step S4, the second powder is molded and second sintered.

According to some embodiments of the present disclosure, the method includes: mixing the main composition with the auxiliary composition to form a first mixture; mixing the first mixture with a solvent and a dispersant to form a second mixture; wet-grinding and drying the second mixture to form a first powder; pre-sintering the first powders to obtain a pre-sintered first powder; mixing the pre-sintered first powder with CeO₂ and P₂O₅ to obtain a second powder; ball-milling and screening the a second powder to obtain a third powder; and molding and sintering the third powder.

According to some embodiments of the present disclosure, the first grinding of step S2 is performed by wet grinding. The wet grinding is carried out under a grinding speed of 400 r/min to 450 r/min for 8 hours to 12 hours.

According to some embodiments of the present disclosure, the method further includes drying the first grinded product at step S2. The drying is performed under a temperature of 60 °C to 80 °C for 10 hours to 20 hours.

According to some embodiments of the present disclosure, the first sintering includes: first heating a grinded product (dried product, if a drying step is included) obtained from the first grinding step to a temperature of 700 °C to 950 °C with a temperature increasing rate of 3 °C/min to 5 °C/min; and maintaining a heated product obtained from the first heating step product at the temperature of 700 °C to 950 °C for 1 hour to 4 hours. In some embodiments, the method further includes cooling the first sintered product.

According to some embodiments of the present disclosure, the second grinding of step S2 is performed by ball-milling. The ball-milling is performed under a grinding speed of 300 r/min to 450 r/min for 4 hours to 10 hours.

According to some embodiments of the present disclosure, the molding is performed by at least one of tape casting, coating, pressing molding, and injection molding.

According to some embodiments of the present disclosure, the second sintering includes: second heating a sintered product obtained from the first sintering step to a temperature of 1000 °C to 1150 °C with a temperature increasing rate of 0.5 °C/min to 3 °C/min; and maintaining a heated product obtained from the second heating step at the temperature of 1000 °C to 1150 °C for 2 hours to 4 hours. In some embodiments, the method further includes cooling the second sintered product.

According to embodiments of the present disclosure, CeO₂ and P₂O₅ are added, and the molar ratio of CeO₂ to P₂O₅ is 1: 1 to 2: 1. The CeO₂ and P₂O₅ may have a synergistic effect on each other, and therefore the resistivity and the initial magnetic permeability of the prepared wave absorbing material may be improved. In addition, the magnetic loss of the wave absorbing material may be decreased to a very low level, which may greatly improve the charging efficiency of a device using this wave absorbing material.

Some illustrative and non-limiting examples are provided hereunder for a better understanding of the present invention and for its practical embodiment.

### Embodiment 1

The present embodiment E1 provides a wave absorbing material and a method of preparing the wave absorbing material.

The main composition and the sintering additive were mixed together to form a first mixture, and then the solvent and the dispersant were added into the first mixture to form a second mixture. The second mixture was grinded by wet grinding with a grinding speed of 450 r/min for 8 hours to obtain first powders. Detailed compositions and contents of the main composition, sintering additive, solvent, and dispersant are shown in Table 1.

The first powders were placed in a vessel and dried in a dryer at 80 °C for 10 hours.

The dried powders were comminuted and pre-sintered in a sintering furnace. Specifically, the comminuted powders were heated to 950 °C with a temperature increasing rate of 5 °C/min, and then kept at 950 °C for 2 hours. Then the sintered powders were cooled together with the sintering furnace.

The pre-sintered powders were mixed with CeO₂ and P₂O₅, ball-milled with a rotation speed of 400 r/min for 6 h, and screened to form second powders.

The second powders were molded into a ring by pressing molding. The ring had an outer diameter of 20 mm, an inner diameter of 5 mm, and a height of 8 mm.

The molded product was sintered to form the wave absorbing material A1. Specifically, the molded product was heated to 300 °C with a temperature increasing rate of 2 °C /min, and then kept at 300 °C for 30 min; then the temperature was increased from 300 °C to 550 °C and the product was kept at 550 °C for 30 min; then the temperature was increased from 550 °C to 900 °C and the product was kept at 900 °C for 60 min; and then the temperature was increased from 900 °C to 1100 °C and the product was kept at 1100 °C for 120 min. Finally, the sintered product was cooled together with the sintering furnace.

### Embodiments 2-7 (E2 to E7)

The methods for preparing the wave absorbing material A2-A7 are substantially the same as that in Embodiment 1, with the exception that the content of corresponding wave absorbing material is different and described in Table 1.

### Comparing Embodiments 1-3 (CE1 to CE3)

The methods for preparing the wave absorbing material CA1-CA3 are substantially the same as that in Embodiment 1, with the exception that the content of corresponding wave absorbing material is different and described in Table 1.

### Comparing Embodiment 4 (CE4)

The wave absorbing material CA4 was prepared according to the Embodiment 1 of CN102211929A.

**Table 1**

| | E1 | E2 | E3 | E4 | E5 | E6 | E7 | CE1 | CE2 | CE3 |
|---|---|---|---|---|---|---|---|---|---|---|
| Fe₂O₃ | 1 | 1 | 1 | 1 | 1 | 1 | 1 | 1 | 1 | 1 |
| MnO | 0.3 | 0.36 | 0.3 | 0.3 | 0.3 | 0.3 | 0.3 | 0.3 | 0.3 | 0.3 |
| ZnO | 0.5 | 0.5 | 0.5 | 0.5 | 0.5 | 0.5 | 0.5 | 0.5 | 0.5 | 0.5 |
| MgO | 0.22 | 0.2 | 0.2 | 0.2 | 0.2 | 0.2 | 0.2 | 0.2 | 0.2 | 0.2 |
| CeO₂ | 0.04 | 0.06 | 0.04 | 0.05 | 0.05 | 0.077 | 0.002 | 0 | 0.04 | 0 |
| P₂O₅ | 0.02 | 0.04 | 0.03 | 0.04 | 0.05 | 0.055 | 0.002 | 0 | 0 | 0.04 |
| Nb₂O₅ | 0.02 | 0.02 | 0.02 | 0.02 | 0.02 | 0.02 | 0.02 | 0.02 | 0.02 | 0.02 |
| MoO₃ | 0.015 | 0.015 | 0.015 | 0.015 | 0.015 | 0.015 | 0.015 | 0.015 | 0.015 | 0.015 |
| Bi₂O₃ | 0.02 | 0.02 | 0.02 | 0.02 | 0.02 | 0.02 | 0.02 | 0.02 | 0.02 | 0.02 |
| V₂O₅ | 0.01 | 0.01 | 0.01 | 0.01 | 0.01 | 0.007 | 0.01 | 0.01 | 0.01 | 0.01 |
| SiO₂ | 0.01 | 0.01 | 0.01 | 0.01 | 0.01 | 0.007 | 0.01 | 0.01 | 0.01 | 0.01 |

### TESTS

### 1) Initial Magnetic Permeability

The initial magnetic permeability was tested by using an HP4284A impedance analyzer commercially available from Aglient Technologies, Inc, US and a special fixture 16454A. The pre-sintered powders to be tested were molded into a cylinder by pressing molding. The cylinder had an outer diameter of 20 mm, an inner diameter of 5 mm, and a height of 8 mm. The cylinder was considered as a single-turn coil. The inductance of the coil was obtained by detecting its impedance, and then the initial magnetic permeability of the tested material can be calculated. The testing frequency was 100 kHz. The results are shown in Table 2.

### 2) Resistivity

Resistivity was tested by using RT-100 resistivity meter commercially available from Semilab company. The powders to be tested were molded into a cube having a length of 20 mm to 25 mm and a cross-section diagonal length of 10 mm to 15 mm. The cube was tested in the resistivity meter, and then the resistivity was calculated according to the manual. The results are shown in Table 2.

**Table 2**

| | Initial Magnetic Permeability | Resistivity (ρ/Ω·m) |
|---|---|---|
| A1 | 7000 | 4.75 |
| A2 | 12000 | 5.68 |
| A3 | 7200 | 4.55 |
| A4 | 7500 | 4.72 |
| A5 | 10000 | 5.63 |
| A6 | 9800 | 5.2 |
| A7 | 7010 | 4.8 |
| CA1 | 4200 | 2.51 |
| CA2 | 5500 | 4.33 |
| CA3 | 5400 | 4.98 |
| CA4 | 4000 | 2.3 |

It can be seen from Table 2 that, the wave absorbing material according to embodiments of the present disclosure has not only higher initial magnetic permeability, but also higher resistivity. The wave absorbing materials prepared according to the Comparative Embodiments have a high initial magnetic permeability, however, they have relatively lower resistivity.

Reference throughout this specification to "an embodiment," "some embodiments," "one embodiment", "another example," "an example," "a specific example," or "some examples," means that a particular feature, structure, material, or characteristic described in connection with the embodiment or example is included in at least one embodiment or example of the present disclosure. Thus, the appearances of the phrases such as "in some embodiments," "in one embodiment", "in an embodiment", "in another example," "in an example," "in a specific example," or "in some examples," in various places throughout this specification are not necessarily referring to the same embodiment or example of the present disclosure. Furthermore, the particular features, structures, materials, or characteristics may be combined in any suitable manner in one or more embodiments or examples.

## Claims

1. A wave absorbing material comprising:
a main composition comprising at least one of Fe₂O₃, MnO, ZnO and MgO;
an auxiliary composition comprising at least CeO₂ and P₂O₅; and
a sintering additive,
**characterized in that**
a molar ratio of CeO₂ to P₂O₅ is 1: 1 to 2: 1, and
that based on the total molar amount of the wave absorbing material,
the content of the Fe₂O₃ is 40 mol% to 54 mol%,
the content of the MnO is 12 mol% to 20 mol%, the content of the ZnO is 22 mol% to 25 mol%,
the content of the MgO is 5 mol% to 10 mol%,
the content of the CeO₂ is 0.1 mol% to 3.5 mol%,
the content of the P₂O₅ is 0.1 mol% to 2.5 mol%, and
the content of the sintering additive is 0.2 mol% to 3.5 mol%.

2. The wave absorbing material of claim 1, wherein based on the total molar amount of the wave absorbing material,
the content of the Fe₂O₃ is 45 mol% to 50 mol%,
the content of the MnO is 13 mol% to 16 mol%,
the content of the ZnO is 22 mol% to 25 mol%,
the content of the MgO is 5 mol% to 10 mol%,
the content of the CeO₂ is 1.5 mol% to 3.0 mol%,
the content of the P₂O₅ is 1 mol% to 2 mol%, and
the content of the sintering additive is 0.2 mol% to 3.5 mol%.

3. The wave absorbing material according to claims 1 or 2, wherein the sintering additive is at least one selected from the group consisting of Nb₂O₅, MoO₃, Bi₂O₃, V₂O₅ and SiO₂.

4. The wave absorbing material of claim 3, wherein based on the total molar amount of the wave absorbing material,
the content of the Nb₂O₅ is 0.1 mol% to 2.5 mol%,
the content of the MoO₃ is 0.1 mol% to 1.5 mol%,
the content of the Bi₂O₃ is 0.2 mol% to 1.5 mol%,
the content of the V₂O₅ is 0.1 mol% to 1.5 mol%, and
the content of the SiO₂ is 0.2 mol% to 2.5 mol%.

5. A method of preparing a wave absorbing material according to any of claims 1-4, comprising steps of:
providing a mixture comprising the main composition and the sintering additive as defined in claim 1;
first grinding and first sintering the mixture together with a solvent and a dispersant to form a first powder;
second grinding the first powder together with CeO₂ and P₂O₅ to form a second powder; and
molding and second sintering the second powder.

6. The method of claim 5, wherein the first grinding is performed by wet grinding.

7. The method of claim 5 or 6, wherein the second grinding is performed by ball-milling.

8. The method of any of claims 6 and 7, wherein the first grinding is performed with a grinding speed of 400 r/min to 450 r/min for 8 hours to 12 hours.

9. The method of any of claims 6-8, wherein the first sintering comprises:
first heating a grinded product obtained from the first grinding step to a temperature of 700 °C to 950 °C with a temperature increasing rate of 3 °C/min to 5 °C/min;
maintaining a heated product obtained from the first heating step at the temperature of 700 °C to 950 °C for 1 hour to 4 hours.

10. The method of any of claims 6-9, wherein the second grinding is performed with a grinding speed of 300 r/min to 450 r/min for 4 hours to 10 hours.

11. The method of any of claims 6-10, wherein the molding is performed by at least one of blade casting, coating, pressing molding, and injection molding.

12. The method of any of claims 6-11, wherein the second sintering comprises second heating a sintered product obtained from the first sintering step to a temperature of 1000 °C to 1150 °C with a temperature increasing rate of 0.5 °C/min to 3 °C/min; and
maintaining a heated product obtained from the second heating step at the temperature of 1000 °C to 1150 °C for 2 hours to 4 hours.

13. The method of any of claims 6-12, further comprising screening the second powders before the molding step.

14. The method of any of claims 6-13, further comprising drying a grinded product obtained from the first grinding step before the first sintering step.

15. The method of claim 14, wherein the drying is performed at a temperature of 60 °C to 80 °C for 10 hours to 20 hours.

## Patentansprüche

1. Wellen-absorbierendes Material, enthaltend:
eine Hauptzusammensetzung, enthaltend zumindest eines von Fe₂O₃, MnO, ZnO und MgO;
eine Hilfszusammensetzung, enthaltend zumindest CeO₂, und P₂O₅; und
ein Sinteradditiv,
**dadurch gekennzeichnet, dass**
ein molares Verhältnis von CeO₂ zu P₂O₅ 1:1 bis 2:1 ist und
dass, bezogen auf die gesamte molare Menge des Wellen-absorbierenden Materials,
der Gehalt von Fe₂O₃ 40 bis 54 mol%,
der Gehalt von MnO 12 bis 20 mol%, der Gehalt von ZnO 22 bis 25 mol%,
der Gehalt von MgO 5 bis 10 mol%,
der Gehalt von CeO₂ 0,1 bis 3,5 mol%,
der Gehalt von P₂O₅ 0,1 bis 2,5 mol% und
der Gehalt des Sinteradditivs 0,2 bis 3,5 mol% ist.

2. Wellen-absorbierendes Material gemäß Anspruch 1, worin, bezogen auf die gesamte molare Menge des Wellen-absorbierenden Materials,
der Gehalt von Fe₂O₃ 45 bis 50 mol%,
der Gehalt von MnO 13 bis 16 mol%,
der Gehalt von ZnO 22 bis 25 mol%,
der Gehalt von MgO 5 bis 10 mol%,
der Gehalt von CeO₂ 1,5 bis 3,0 mol%,
der Gehalt von P₂O₅ 1 bis 2 mol% und
der Gehalt des Sinteradditivs 0,2 bis 3,5 mol% ist.

3. Wellen-absorbierendes Material gemäß Anspruch 1 oder 2, worin das Sinteradditiv zumindest eines ist, ausgewählt aus der Gruppe, bestehend aus Nb₂O₅, MoO₃, Bi₂O₃, V₂O₅ und SiO₂.

4. Wellen-absorbierendes Material gemäß Anspruch 3, worin, bezogen auf die gesamte molare Menge des Wellen-absorbierenden Materials,
der Gehalt von Nb₂O₅ 0,1 bis 2,5 mol%,
der Gehalt von MoO₃ 0,1 bis 1,5 mol%,
der Gehalt von Bi₂O₃ 0,2 bis 1,5 mol%,
der Gehalt von V₂O₅ 0,1 bis 1,5 mol% und
der Gehalt von SiO₂ 0,2 bis 2,5 mol% ist.

5. Verfahren zur Herstellung eines Wellen-absorbierenden Materials gemäß einem der Ansprüche 1 bis 4, enthaltend die Schritte:
Vorsehen einer Mischung, enthaltend die Hauptzusammensetzung und das Sinteradditiv wie in Anspruch 1 definiert;
erstes Mahlen und erstes Sintern der Mischung zusammen mit einem Lösungsmittel und einem Dispergiermittel, zur Bildung eines ersten Pulvers;
zweites Mahlen des ersten Pulvers zusammenmit CeO₂ und P₂O₅, zur Bildung eines zweiten Pulvers; und
Formen und zweites Sintern des zweiten Pulvers.

6. Verfahren gemäß Anspruch 5, worin das erste Mahlen durch Nassmahlen durchgeführt wird.

7. Verfahren gemäß Anspruch 5 oder 6, worin das zweite Mahlen durch Kugelmahlen durchgeführt wird.

8. Verfahren gemäß Anspruch 6 und 7, worin das erste Mahlen mit einer Mahlgeschwindigkeit von 400 bis 450 UpM für 8 bis 12 Stunden durchgeführt wird.

9. Verfahren gemäß einem der Ansprüche 6 bis 8, worin das erste Sintern enthält:
erstes Erwärmen eines gemahlenen Produktes, erhalten von dem ersten Mahlschritt, auf eine Temperatur von 700 bis 950°C mit einer Temperaturerhöhungsrate von 3 bis 5°C/min;
Halten des erwärmten Produktes, erhalten von dem ersten Erwärmungsschritt, bei der Temperatur von 700 bis 950°C für 1 bis 4 Stunden.

10. Verfahren gemäß einem der Ansprüche 6 bis 9, worin das zweite Mahlen mit einer Mahlgeschwindigkeit von 300 bis 450 UpM für 4 bis 10 Stunden durchgeführt wird.

11. Verfahren gemäß einem der Ansprüche 6 bis 10, worin das Mahlen durch zumindest einem von Blattgießen, Beschichten, Pressformen und Injektionsformen durchgeführt wird.

12. Verfahren gemäß einem der Ansprüche 6 bis 11, worin das zweite Sintern enthält:
zweites Erwärmen eines Sinterproduktes, erhalten von dem ersten Sinterschritt, auf eine Temperatur von 1.000 bis 1.150°C mit einer Temperaturerhöhungsrate von 0,5 bis 3°C/min und
Halten eines erwärmten Produktes, erhalten von dem zweiten Erwärmungsschritt, bei der Temperatur von 1.000 bis 1.150°C für 2 bis 4 Stunden.

13. Verfahren gemäß einem der Ansprüche 6 bis 12, weiter enthaltend das Sieben der zweiten Pulver vor dem Mahlschritt.

14. Verfahren gemäß einem der Ansprüche 6 bis 13, weiterhin enthaltend das Trocknen eines gemahlenen Produktes, erhalten von dem ersten Mahlschritt vor dem ersten Sinterschritt.

15. Verfahren gemäß Anspruch 14, worin das Trocknen bei einer Temperatur von 60 bis 80°C für 10 bis 20 Stunden durchgeführt wird.

## Revendications

1. Matériau d'absorption d'ondes comprenant :
une composition principale comprenant au moins l'un de Fe₂O₃, MnO, ZnO et MgO;
une composition auxiliaire comprenant au moins de CeO₂ et P₂O₅; et
un additif de frittage,
**caractérisé en ce que**
un rapport molaire de CeO₂ sur P₂O₅ est de 1:1 à 2:1, et
**en ce que** sur la base de la quantité molaire totale du matériau d'absorption d'ondes,
la teneur du Fe₂O₃ est de 40 % en mole à 54 % en mole,
la teneur du MnO est de 12 % en mole à 20 % en mole,
la teneur du ZnO est de 22 % en mole à 25 % en mole,
la teneur du MgO est de 5 % en mole à 10 % en mole,
la teneur du CeO₂ est de 0,1 % en mole à 3,5 % en mole,
la teneur du P₂O₅ est de 0,1 % en mole à 2,5 % en mole, et
la teneur de l'additif de frittage est de 0,2 % en mole à 3,5 % en mole.

2. Matériau d'absorption d'ondes selon la revendication 1, dans lequel, sur la base de la quantité molaire totale du matériau d'absorption d'ondes,
la teneur du Fe₂O₃ est de 45 % en mole à 50 % en mole,
la teneur du MnO est de 13 % en mole à 16 % en mole,
la teneur du ZnO est de 22 % en mole à 25 % en mole,
la teneur du MgO est de 5 % en mole à 10 % en mole,
la teneur du CeO₂ est de 1,5 % en mole à 3,0 % en mole,
la teneur du P₂O₅ est de 1 % en mole à 2 % en mole, et
la teneur de l'additif de frittage est de 0,2 % en mole à 3,5 % en mole.

3. Matériau d'absorption d'ondes selon les revendications 1 ou 2, dans lequel l'additif de frittage est au moins l'un sélectionné à partir du groupe constitué par Nb₂O₅, MoO₃, Bi₂O₃, V₂O₅ et SiO₂.

4. Matériau d'absorption d'ondes selon la revendication 3, dans lequel, sur la base de la quantité molaire totale du matériau d'absorption d'ondes,
la teneur du Nb₂O₅ est de 0,1 % en mole à 2,5 % en mole,
la teneur du MoO₃ est de 0,1 % en mole à 1,5 % en mole,
la teneur du Bi₂O₃ est 0,2 % en mole à 1,5 % en mole,
la teneur du V₂O₅ est de 0,1 % en mole à 1,5 % en mole, et
la teneur du SiO₂ est de 0,2 % en mole à 2,5 % en mole.

5. Procédé de préparation d'un matériau d'absorption d'ondes selon l'une quelconque des revendications 1 à 4, comprenant les étapes suivantes :
fourniture d'un mélange comprenant la composition principale et l'additif de frittage tels que définis dans la revendication 1 ;
un premier broyage et un premier frittage du mélange avec un solvant et un dispersant pour former une première poudre ;
un second broyage de la première poudre avec du CeO₂ et du P₂O₅ pour former une seconde poudre ; et
un moulage et un second frittage de la seconde poudre.

6. Procédé selon la revendication 5, dans lequel le premier broyage est effectué par un broyage humide.

7. Procédé selon la revendication 5 ou 6, dans lequel le second broyage est effectué par broyage à billes.

8. Procédé selon l'une quelconque des revendications 6 et 7, dans lequel le premier broyage est effectué à une vitesse de broyage de 400tr/min à 450tr/min pendant 8 heures à 12 heures.

9. Procédé selon l'une quelconque des revendications 6 à 8, dans lequel le premier frittage comprend :
un premier chauffage d'un produit broyé obtenu dans la première étape de broyage à une température de 700°C à 950°C avec une vitesse d'augmentation de température de 3°C/min à 5°C/min ;
le maintien d'un produit chauffé obtenu dans la première étape de chauffage à la température de 700°C à 950°C pendant 1 heure à 4 heures.

10. Procédé selon l'une quelconque des revendications 6 à 9, dans lequel le second broyage est effectué à une vitesse de broyage de 300tr/min à 450tr/min pendant 4 heures à 10 heures.

11. Procédé selon l'une quelconque des revendications 6 à 10, dans lequel le moulage est effectué par au moins l'un d'une coulée à la lame, d'une application en revêtement, d'un moulage sous pression et d'un moulage par injection.

12. Procédé selon l'une quelconque des revendications 6 à 11, dans lequel le second frittage comprend
un second chauffage d'un produit fritté obtenu dans la première étape de frittage à une température de 1000°C à 1150°C avec une vitesse d'augmentation de température de 0,5°C/min à 3°C/min ; et
le maintien d'un produit chauffé obtenu dans la seconde étape de chauffage à la température de 1000°C à 1150°C pendant 2 heures à 4 heures.

13. Procédé selon l'une quelconque des revendications 6 à 12, comprenant en outre le criblage des secondes poudres avant l'étape de moulage.

14. Procédé selon l'une quelconque des revendications 6 à 13, comprenant en outre le séchage d'un produit broyé obtenu dans la première étape de broyage avant la première étape de frittage.

15. Procédé selon la revendication 14, dans lequel le séchage est effectué à une température de 60°C à 80°C pendant 10 heures à 20 heures.
